# EUROPEAN PATENT APPLICATION

(11) **EP 2 076 106 A2**
(43) Date of publication of application: **01.07.2009**
(21) Application number: 08162233.4
(22) Date of filing: 12.08.2008
(51) Int. Cl.: H05K 3/46

(54) **Multilayer wiring board and method of manufacturing the same**

(30) Priority: 27.12.2007 JP 2007337395
(71) Applicant: Fujitsu Limited, Kawasaki-shi, Kanagawa 211-8588 (JP)
(72) Inventor: Matsui, Akiko, Fujitsu Advanced Technologies Limited, Kawasaki-shi, Kanagawa 211-8588 (JP)
(74) Representative: Stebbing, Timothy Charles

(57) **Abstract**

A multilayer wiring board (1A) is manufactured by preparing a first wiring board (10), a second wiring board (20), and a joint sheet (30). The first wiring board (10) is provided with a via (12) having a first through-hole (11) in which a conductive film is formed. The second wiring board (20) is provided with a second through-hole (21) at a position substantially matching the position of the first through-hole (11). The joint sheet (30) is provided with a third through-hole (31) at a position substantially matching the positions of the first and the second through-holes (11, 21). the first wiring board (10) and the second wiring board (20) are stacked and bonded together by heat and pressure with the joint sheet (30) interposed therebetween.

## Description

The present invention relates to a multilayer wiring board and a method of manufacturing the same.

Recently, a high-density printed wiring board having a multilayer structure is required for use in an electronic device along with the size reduction and higher performances. As a wiring board realizing the multilayer structure and high densification, an interstitial via hole (IVH) multilayer board having a via electrically connecting specific layers is known (see Japanese Patent Applications Laid-open Nos. 2006-13172, 2000-22032, and 03-58491, for example). The IVH multilayer board (hereinafter, "multilayer wiring board") is constituted by an insulating member. Conductive patterns are formed on both sides of the insulating member. An internal conductive pattern is formed in the insulating member. The conductive patterns and the internal conductive pattern are coupled and electrically connected by a plurality of vias.

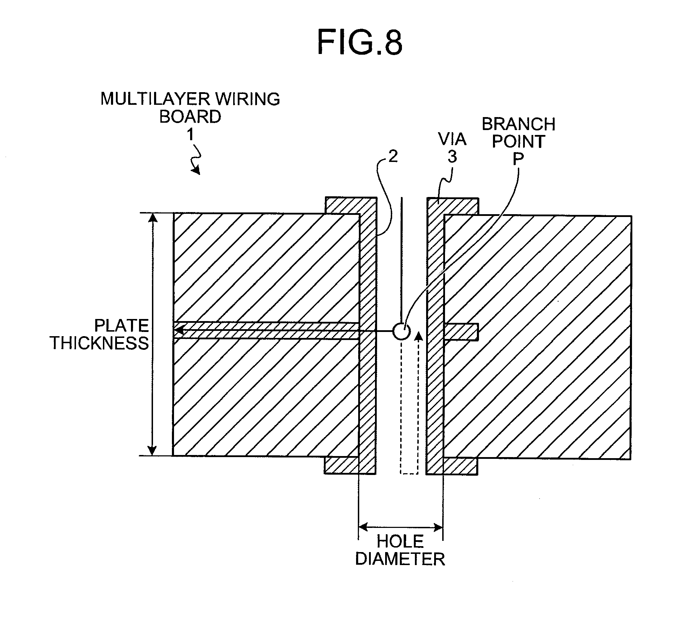

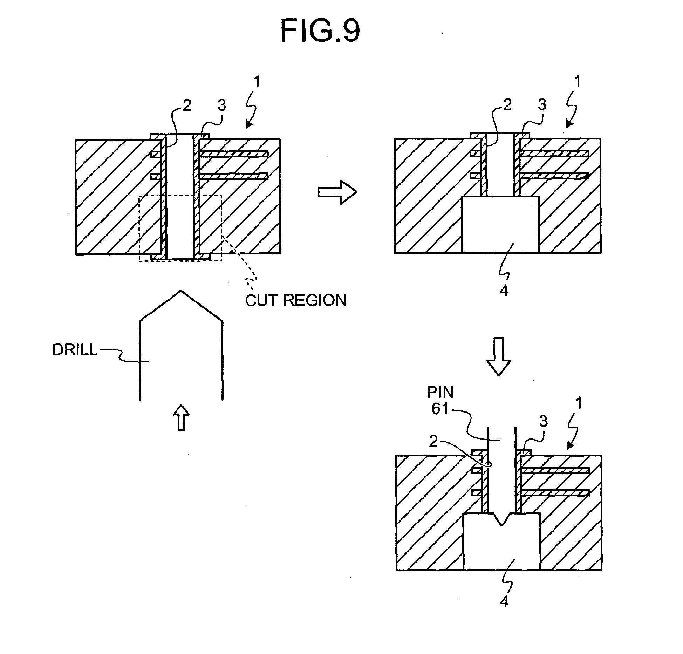

A structure of a conventional multilayer wiring board is described with reference to Fig. 8. Fig. 8 is a schematic diagram of a conventional multilayer wiring board 1 having a via. Fig. 9 is a schematic diagram for explaining the process of manufacturing the conventional multilayer wiring board 1. As shown in Fig. 8, the multilayer wiring board 1 has a via 3 having a through-hole 2 formed in between layers of the wiring board. The multilayer wiring board 1 has a structure in which signal wiring patterns are electrically connected with another via (not shown) of a different layer in the wiring board by the via 3. In the structure of the conventional multilayer wiring board 1, the through-hole 2 formed in the via 3 is plated with copper or the like. However, the conventional multilayer wiring board 1 shown in Fig. 8 has a problem of adverse influence of a stub (branched portion where a transmission path of electric signals is branched) on electric characteristics of a via.

Specifically, in the conventional multilayer wiring board 1, when a signal path of the via 3 branches into two directions, an electric signal is transmitted in a direction that is not a signal path (stub side). The electric signal (dotted line in Fig. 8) is reflected when it reaches the end of the via 3 and then returns to a branch point P, at which point electric signals collide with each other, exerting adverse influence on electric characteristic. The influence becomes more noticeable with high-frequency signals or high-speed digital signals.

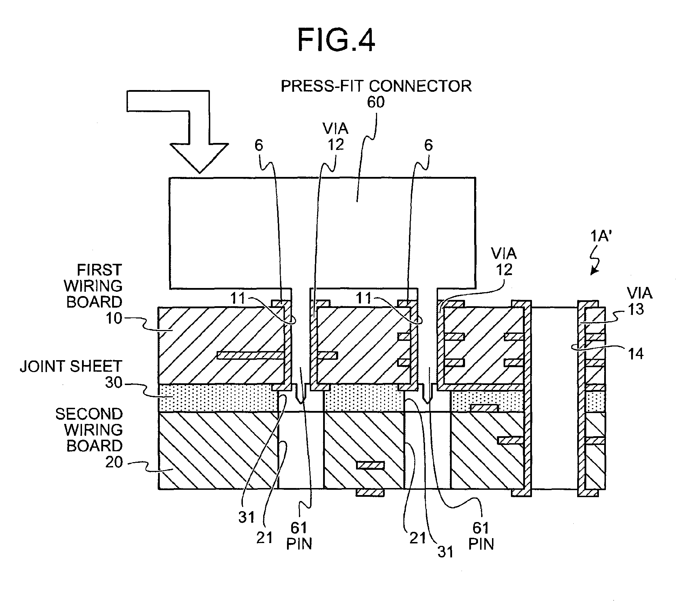

To solve the problem attributed to the stub, a measure has been taken in which a drill larger than the diameter (hole diameter) of a through-hole formed in the via is used to cut out a part (unnecessary part) of the through-hole (back-drill method). The outline of the back-drill method is described below with reference to Fig. 9. In Fig. 9, a pin 61 of a press-fit connector 60 (Fig. 4) is press-fitted to the through-hole 2 formed in the via 3.

As shown in Fig. 9, a cut region of the through-hole 2 formed in the via 3 is cut out (removed) from one side of the via 3 (bottom side in Fig. 9) by using a drill. As shown in Fig. 9, because a plated region (conductive region) that is plated with copper or the like is not present in a lower half 4 of the through-hole 2 of the via 3, the multilayer wiring board 1 having the via 3 that can avoid adverse influence of reflection of electric signals due to a stub can be manufactured.

However, when the back-drill method is employed in manufacturing the conventional multilayer wiring board, more labor hours are necessary for cutting a through-hole by back-drilling and the processing of cutting is difficult. Specifically, when the aspect ratio of a via (the diameter of the through-hole/the total plate thickness of the multilayer wiring board) exceeds a predetermined value (numerical value: 10), the processing of plating the inside of the via with copper and the processing of forming a through-hole in a wiring board become difficult.

When the back-drill method is employed, a via needs to be prepared longer than necessary temporarily to form a part of the via as a cut region, and extra work of cutting the part of the via (through-hole) by back-drilling is necessary for manufacturing a multilayer wiring board. This increases cost and manufacturing time.

The conventional technologies disclosed in Japanese Patent Applications Laid-open Nos. 2006-13172, 2000-22032, and 03-58491 also involve problems that the back-drill method cannot provide a wiring board or a through-hole depending on their shapes (sizes) and that longer time is necessary for manufacturing.

The present invention has been developed in view of the problems in the conventional technology.

According to an aspect of the present invention, there is provided a method of manufacturing a multilayer wiring board in which a via is formed, including: preparing a first wiring board with the via that electrically connects signal wiring patterns of different layers of the multilayer wiring board, and has a first through-hole an inner surface of which is coated with a conductive film; preparing a second wiring board with a second through-hole formed at a position substantially matching a position of the first through-hole; preparing a joint sheet with a third through-hole formed at a position substantially matching positions of the first through-hole and the second through-hole; stacking the first wiring board and the second wiring board with the joint sheet interposed between the first wiring board and the second wiring board; and bonding the first wiring board, the second wiring board, and the joint sheet by heat and pressure.

According to another aspect of the present invention, there is provided a method of manufacturing a multilayer wiring board in which a via is formed, including: preparing a first wiring board with the via that electrically connects signal wiring patterns of different layers of the multilayer wiring board, and has a first through-hole an inner surface of which is coated with a conductive film; preparing a second wiring board with a second through-hole formed at a position substantially matching a position of the first through-hole; preparing a first joint sheet with a third-through-hole formed at a position substantially matching positions of the first through-hole and the second through-hole; preparing a third wiring board with a fourth through-hole formed at a position substantially matching the position of the second through-hole; preparing a second joint sheet with a fifth through-hole formed at a position substantially matching the positions of the second through-hole and the fourth through-hole; stacking the first wiring board, the second wiring board, and the third wiring board with the first joint sheet interposed between the first wiring board and the second wiring board and with the second joint sheet interposed between the second wiring board and the third wiring board; and bonding the first wiring board, the second wiring board, the third wiring board, the first joint sheet, and the second joint sheet by heat and pressure.

According to still another aspect of the present invention, there is provided a multilayer wiring board in which a via is formed at a predetermined position, including: a first wiring board that is provided with the via that electrically connects signal wiring patterns of different layers of the wiring board, and has a first through-hole an inner surface of which is coated with a conductive film; a second wiring board that is provided with a second through-hole formed at a position substantially matching a position of the first through-hole; and a joint sheet that is provided with a third through-hole formed at a position substantially matching positions of the first through-hole and the second through-hole, and is interposed between the first wiring board and the second wiring board.

The above and other features, advantages and technical and industrial significance of this invention will be better understood by reading the following detailed description of presently preferred embodiments of the invention, when considered in connection with the accompanying drawings, in which:
Fig. 1 is a schematic diagram of a multilayer wiring board according to a first embodiment of the present invention;
Figs. 2A, 2B, and 2C are schematic diagrams for explaining the process of manufacturing the multilayer wiring board shown in Fig. 1;
Fig. 3 is a flowchart of the process of manufacturing the multilayer wiring board shown in Fig. 1;
Fig. 4 is a schematic diagram of a multilayer wiring board according to a second embodiment of the present invention;
Fig. 5 is a schematic diagram of a multilayer wiring board according to a third embodiment of the present invention;
Figs. 6A, 6B, and 6C are schematic diagrams for explaining the process of manufacturing the multilayer wiring board shown in Fig. 5;
Fig. 7 is a flowchart of the process of manufacturing the multilayer wiring board shown in Fig. 5;
Fig. 8 is a schematic diagram of a conventional multilayer wiring board having a via; and
Fig. 9 is a schematic diagram for explaining the process of manufacturing the conventional multilayer wiring board.

Exemplary embodiments of the present invention are explained in detail below with reference to the accompanying drawings.

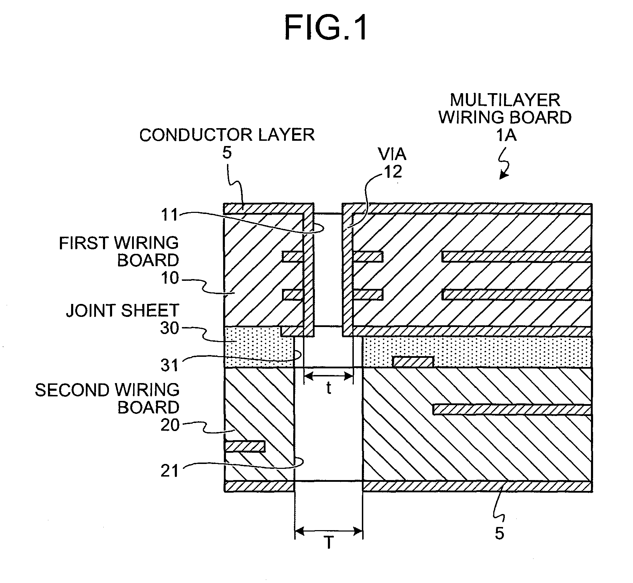

A structure of a multilayer wiring board 1A according to a first embodiment of the present invention is described with reference to Fig. 1. Fig. 1 is a schematic diagram of the multilayer wiring board 1A. The multilayer wiring board 1A is characterized in that adverse influence of stubs on electric characteristics can be reduced because a lower half of a via 12 provided to the multilayer wiring board 1A is a through-hole to which no conductive film such as copper plating is formed.

As shown in Fig. 1, the multilayer wiring board 1A includes a first wiring board 10, a second wiring board 20, and a joint sheet 30 interposed between the first wiring board 10 and the second wiring board 20, which are stacked and bonded together by heat and pressure. In this structure, the via 12 that electrically connects signal wiring patterns of different layers is formed at a predetermined position (left side in Fig. 1) of the first wiring board 10. As shown in Fig. 1, a through-hole 11 penetrates the via 12 in the vertical or up-down direction of the wiring board. A conductive film such as copper plating is formed over the inner circumference surface of the through-hole 11. A conductor layer 5 having a non-patterned surface is formed over the outermost layer (top surface in Fig. 1) of the first wiring board 10.

Similarly, a through-hole 21 that penetrates the second wiring board 20 in the vertical direction of the wiring board is formed at a predetermined position of the second wiring board 20 (the position where the via 12 is formed, and the coordinate position substantially matching that of the through-hole 11). The through-hole 21 is not plated unlike the through-hole 11 of the first wiring board 10. Similarly to the first wiring board 10, the conductor layer 5 having a non-patterned surface is formed over the outermost layer (bottom surface in Fig. 1) of the second wiring board 20.

Similarly, a through-hole 31 that penetrates the joint sheet 30 in the vertical direction of the sheet is formed at a predetermined position of the joint sheet 30 (the position where the via 12 is formed, and the coordinate position substantially matching those of the through-hole 11 and the through-hole 21). Accordingly, when the first wiring board 10, the second wiring board 20, and the joint sheet 30 are stacked, the through-hole 11 of the via 12, the through-hole 31, and the through-hole 21 are at the positions substantially matching in the vertical direction of the wiring board. A diameter T of the through-hole 21 and the through-hole 31 is set to be larger than a diameter t of the via 12 to reduce reflection of electric signals.

The joint sheet 30 joins the first wiring board 10 and the second wiring board 20 together. In the first embodiment, a no-flow prepreg (a sheet obtained by impregnating a textile such as carbon fiber and glass fiber with resin) that is heat-resistant and from which no impregnated resin flows out (no resin flow) is used. When the no-flow prepreg is used as the joint sheet 30, it is possible to reliably avoid problems such as resin flow from the prepreg during heat-pressure bonding.

The joint sheet 30 may be, instead of the no-flow prepreg, a low-flow prepreg in which less resin flow is observed or a generally used adhesive sheet that has adhesive top and bottom surfaces. The adhesive sheet is interposed between the first wiring board 10 and the second wiring board 20, and the first wiring board 10 and the second wiring board 20 are joined by the adhesive surfaces. Manufacturing cost can be reduced when the adhesive sheet that is inexpensive than the prepreg is used.

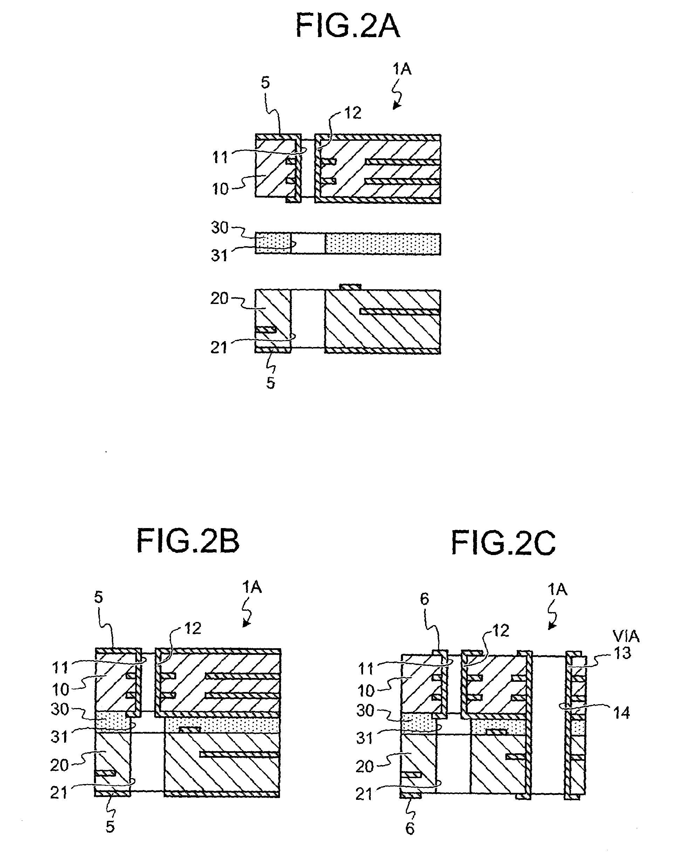

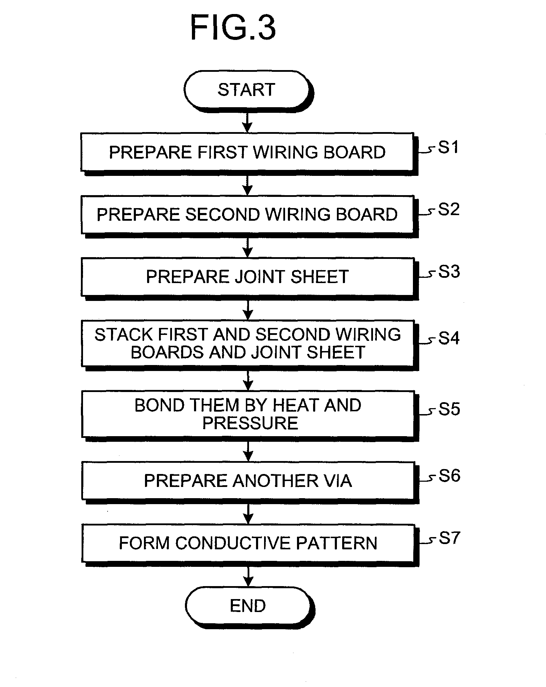

The process of manufacturing the multilayer wiring board 1A is described with reference to Figs. 2A, 2B, 2C, and 3. Figs. 2A, 2B, and 2C are schematic diagrams for explaining the process of manufacturing the multilayer wiring board 1A. Fig. 3 is a flowchart of the process of manufacturing the multilayer wiring board 1A.

As shown in Fig. 2A, first, the first wiring board 10 is prepared in which the via 12 is formed for connecting signal wiring patterns of different layers in the wiring board (step S1). As stated above, the through-hole 11 penetrates the via 12 in the vertical direction of the board. The conductive film such as copper plating is formed on the inner circumference surface of the through-hole 11.

As shown in Fig. 2A, the second wiring board 20 is prepared through which the through-hole 21 penetrates in the vertical direction of the board (step S2). As stated above, the through-hole 21 formed in the second wiring board 20 is positioned to substantially match the through-hole 11 of the via 12 of the first wiring board 10.

As shown in Fig. 2A, the joint sheet 30 is prepared through which the through-hole 31 penetrates in the vertical direction of the board (step S3). As stated above, the through-hole 31 formed in the joint sheet 30 is positioned to substantially match the through-hole 11 of the via 12 formed in the first wiring board 10 and the through-hole 21 formed in the second wiring board 20 (at the same coordinate position).

Next, as shown in Fig. 2B, with the joint sheet 30 being between the first wiring board 10 and the second wiring board 20, the first wiring board 10, the second wiring board 20, and the joint sheet 30 are stacked (step S4), and bonded by heat and pressure (step S5). Thereby, the through-hole 11 of the via 12 of the first wiring board 10 and the through-hole 21 of the second wiring board 20 form a through-hole penetrating the entire wiring board in the vertical direction, completing a via structure of the via 12 formed in the multilayer wiring board 1A.

Next, as shown in Fig. 2C, another via 13 is formed for electrical connection with the signal wiring pattern of the via 12 that penetrates the first wiring board 10 and the second wiring board 20 (step S6). Lastly, a desired conductive pattern 6 is patterned on the outermost layer (the conductor layer 5) of the first wiring board 10 (step S7).

As described above, according to the first embodiment, the multilayer wiring board 1A includes the first wiring board 10, the second wiring board 20, and the joint sheet 30 interposed therebetween, which are stacked and bonded together by heat and pressure. The first wiring board 10 is provided with the via 12 having the through-hole 11 the inner surface of which is coated with a conductive film. The second wiring board 20 is provided with the through-hole 21 formed at the position substantially matching the position of the through-hole 11. The joint sheet 30 is provided with the through-hole 31 formed at the position substantially matching the positions of the through-holes 11 and 21. Therefore, adverse influence of stubs on electric characteristics can be reduced, and the manufacturing cost and time can be reduced.

Fig. 4 is a schematic diagram of a multilayer wiring board 1A' according to a second embodiment of the present invention. As shown in Fig. 4, the multilayer wiring board 1A' is of basically the same configuration as multilayer wiring board 1A, and includes the first wiring board 10, the second wiring board 20, and the joint sheet 30 interposed between the first wiring board 10 and the second wiring board 20 stacked and bonded together by heat and pressure. In the second embodiment, the diameter of through-holes 11 formed in a pair of vias 12 of the first wiring board 10 is set to allow a pair of pins 61 of the press-fit connector 60 to be press-fitted thereto.

In practice, because the pin 61 of the press-fit connector 60 is resiliently compressed when joining to the through-holes 11, the diameter of the pin 61 is larger than the diameter of the through-holes 11. In this case, it is possible to examine the through-holes 11 that are formed in the vias 12 for the purpose of pin-joint (insertion) of the press-fit connector 60 and to examine the insertion state of the pin 61 easily.

As described above, in the multilayer wiring board 1A', the lower half of the through-holes of the vias 12 penetrating the first wiring board 10 and the second wiring board 20 is not plated, and the diameter of the through-holes 11 formed in the pair of vias 12 of the first wiring board 10 is set to allow the pair of pins 61 of the press-fit connector 60 to be press-fitted thereto. Accordingly, it is possible to realize a multilayer wiring board in which adverse influence of stubs on electric characteristics can be reduced even with a press-fit connector used in a high-frequency circuit, high-speed digital circuit, or the like.

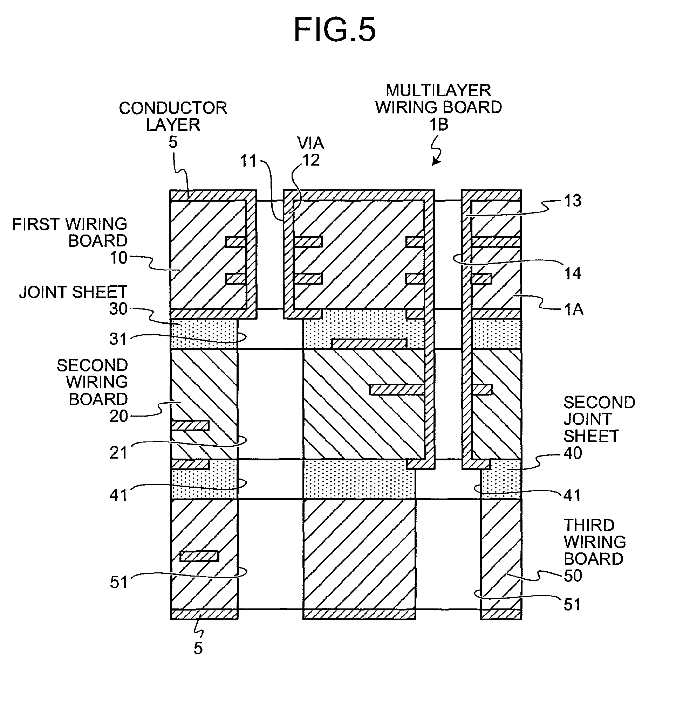

A multilayer wiring board 1B according to a third embodiment of the present invention is explained below with reference to Fig. 5. Fig. 5 is a schematic diagram of the multilayer wiring board 1B. In the third embodiment, the process of manufacturing the multilayer wiring board 1A explained in the first embodiment is repeated several times to make conductive portions of vias have different lengths.

As shown in Fig. 5, the multilayer wiring board 1B is manufactured by preparing a third wiring board 50, in addition to the multilayer wiring board 1A manufactured as previously described in the first embodiment, and stacking and bonding by heat and pressure the multilayer wiring board 1A, the third wiring board 50, and a second joint sheet 40 interposed therebetween. The structure of the multilayer wiring board 1B is described below with reference to Fig. 5.

As shown in Fig. 5, the multilayer wiring board 1A constituting part of the multilayer wiring board 1B is manufactured by, as stated above, stacking and bonding by heat and pressure the first wiring board 10, the second wiring board 20, and the joint sheet 30 interposed between the first wiring board 10 and the second wiring board 20. As stated above, the via 12 having the through-hole 11 to which a conductive film such as copper plating is formed is formed at the predetermined position of the first wiring board 10, and the through-hole 21 is formed at the predetermined position of the second wiring board 20 (the position substantially matching that of the through-hole 11). Similarly, the through-hole 31 is formed at the predetermined position of the joint sheet 30 (the position substantially matching that of the through-hole 11). The conductor layer 5 having a non-patterned surface is formed at the outermost layer (top surface in Fig. 5) of the first wiring board 10.

In the multilayer wiring board 1A configured by joining the first wiring board 10, the second wiring board 20, and the joint sheet 30, in addition to the via 12 formed on a side (left side in Fig. 5), a via 13 having a through-hole 14 the inside of which is plated with copper or the like is formed on the other side (right side in Fig. 5). As shown in Fig. 5, the via 13 penetrates the first wiring board 10, the joint sheet 30, and the second wiring board 20 configuring the multilayer wiring board 1A, in the vertical direction.

The second joint sheet 40 and the third wiring board 50 are stacked on the bottom surface of the second wiring board 20 in this order. The second joint sheet 40 joins the wiring boards together as the joint sheet 30 used in the multilayer wiring board 1A does. The second joint sheet 40 is a heat-resistant, no-flow prepreg.

A pair of through-holes 41 are formed penetrating the second joint sheet 40 in the vertical direction. One of the through-holes 41 (left one in Fig. 5) is formed at a position substantially matching those of the through-hole 21 of the second wiring board 20 and the through-hole 31 of the joint sheet 30. The other of the through-holes 41 (right one in Fig. 5) is formed at a position substantially matching the position where the via 13 penetrating the first wiring board 10, the second wiring board 20, and the joint sheet 30 is formed.

A pair of through-holes 51 are formed penetrating the third wiring board 50 in the vertical direction of the board. The pair of through-holes 51 are not plated unlike the through-hole 11 of the first wiring board 10. One of the through-holes 51 (left one in Fig. 5) is formed at a position substantially matching the through-hole 21 of the second wiring board 20 and the through-hole 31 of the joint sheet 30. The other of the through-holes 51 (right one in Fig. 5) is formed at a position substantially matching the position where the via 13 penetrating the first wiring board 10, the second wiring board 20, and the joint sheet 30 is formed. The conductor pattern 5 having a non-patterned surface is formed at the outermost layer (bottom surface in Fig. 5) of the third wiring board 50. As shown in Fig. 5, the multilayer wiring board 1B is configured by joining the third wiring board 50 to the multilayer wiring board 1A by the second joint sheet 40. Method of Manufacturing Multilayer wiring board

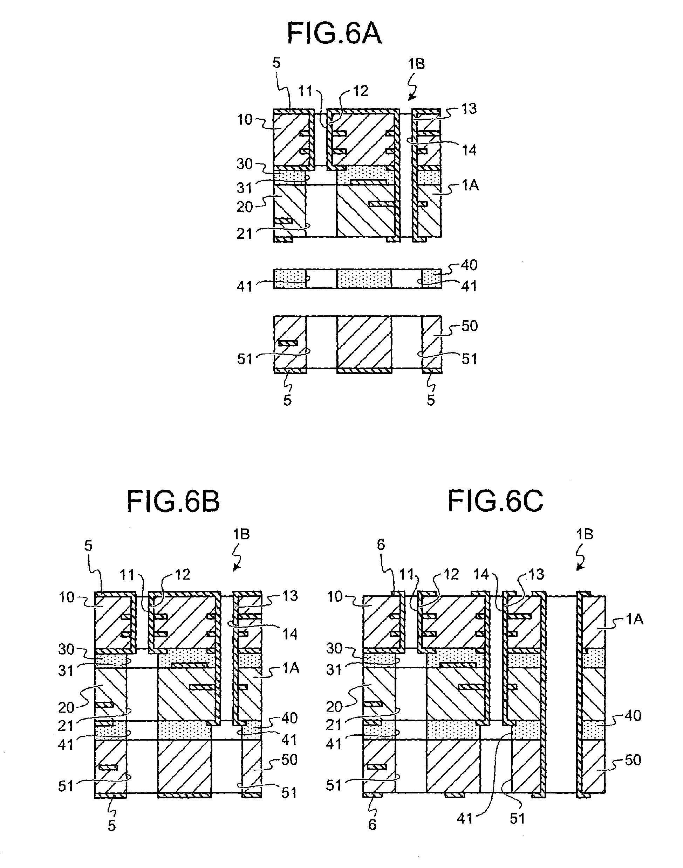

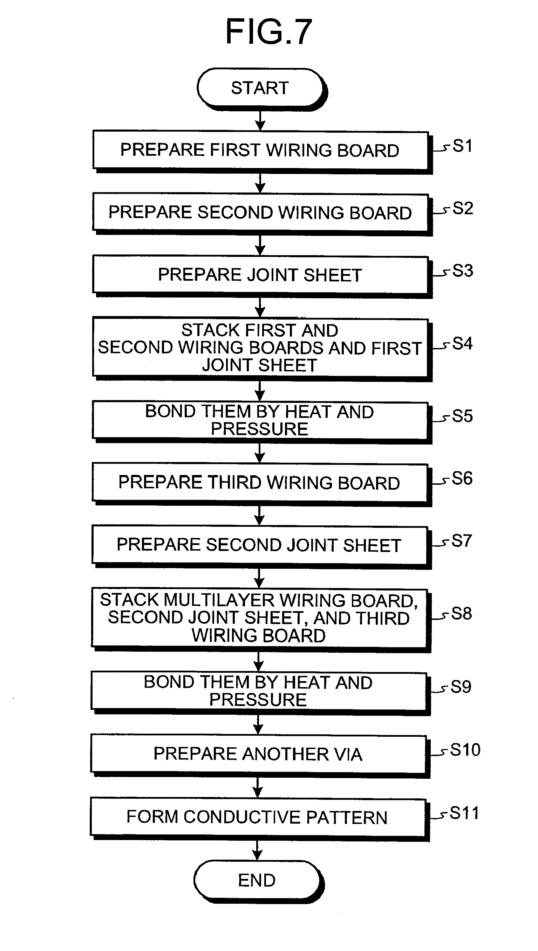

The process of manufacturing the multilayer wiring board 1B is described with reference to Figs. 6A, 6B, 6C, and 7. Figs. 6A, 6B, and 6C are schematic diagrams for explaining the process of manufacturing the multilayer wiring board 1B. Fig. 7 is a flowchart of the process of manufacturing the multilayer wiring board 1B. Detailed explanation of the same procedure as that in the first embodiment is not repeated in the following explanation with reference to Fig. 7.

As shown in Fig. 6A and Fig. 7, the multilayer wiring board 1A is first manufactured in the same manner as previously described for the multilayer wiring board 1A according to the first embodiment. Specifically, the first wiring board 10 is prepared (step S1); the second wiring board is prepared (step S2); the joint sheet 30 of a no-flow prepreg is prepared (step S3); the first wiring board 10 and the second wiring board 20 are stacked with the joint sheet 30 interposed therebetween (step S4); and the first wiring board 10, the second wiring board 20, and the joint sheet 30 are bonded by heat and pressure (step S5).

As shown in Fig. 5, in addition to the via 12, the general via 13 having the through-hole 14 is formed in the multilayer wiring board 1A. As stated above, the via 13 penetrates the first wiring board 10, the joint sheet 30, and the second wiring board 20 that constitute the multilayer wiring board 1A in the vertical direction.

The third wiring board 50 having a size (thickness) substantially the same as that of the second wiring board 20 is prepared (step S6). The second joint sheet 40 for joining the boards together as the joint sheet 30 does is prepared (step S7).

As shown in Fig. 6B and Fig. 7, the second joint sheet 40 and the third wiring board 50 are stacked in this order to the bottom surface of the second wiring board 20 of the multilayer wiring board 1A (step S8), and bonded by heat and pressure (step S9). Thereby, the through-hole 11 of the via 12 of the first wiring board 10, the through-hole 21 of the second wiring board 20, and the through-hole 51 of the third wiring board 50 form a through-hole penetrating the wiring board in the vertical direction, completing a via structure of the via 12 formed in the multilayer wiring board 1B. The through-hole 14 of the via 13 of the first wiring board 10, the through-hole 21 of the second wiring board 20, and the through-hole 51 of the third wiring board 50 form a through-hole penetrating the wiring board in the vertical direction, completing a via structure of the via 13 formed in the multilayer wiring board 1B. The lower halves of the via 12 and the via 13 are configured as through-holes not plated with copper or the like, whereby the configuration reduces adverse influence of stubs.

Next, as shown in Fig. 6C, another via for electric connection with the respective signal wiring patterns of the via 12 and the via 13 is formed at a predetermined position of the multilayer wiring board 1B (step S10). Lastly, a desired conductive pattern 6 is patterned on the outermost layer (the conductor layer 5) of the third wiring board 50 (step S11). By the above-described procedure of the steps S1 to S11, the multilayer wiring board 1B can be manufactured that has the vias 12 and 13 having the through-holes 21 and 51, the lower halves of the inner surfaces of the through-holes 21 and 51 not being plated, and has another via electrically connected to the vias 12 and 13.

As described above, according to the third embodiment, the multilayer wiring board 1B is provided by repeating manufacturing of a multilayer wiring board to make conductive portions of vias, composed of vias and through-holes that are not plated with copper or the like, have different lengths. Therefore, it is possible to select a desired via depending on a layer from which a signal is to be taken out through the via, and also to reduce adverse influence of stubs on electric characteristics.

As set forth hereinabove, according to an embodiment of the present invention, a multilayer wiring board includes a first wiring board, a second wiring board, and a joint sheet interposed therebetween, which are stacked and bonded together by heat and pressure. The first wiring board is provided with a via having a first through-hole the inner surface of which is coated with a conductive film. The second wiring board is provided with a second through-hole formed at a position substantially matching the position of the first through-hole. The joint sheet is provided with a third through-hole formed at a position substantially matching the positions of the through-holes. Therefore, adverse influence of stubs on electric characteristics can be reduced, and the manufacturing cost and time can be shortened. The method is applicable to boards that the back-drill method cannot provide, and part of the via, which is a problem in the back-drill method, is a cut region in this method. This eliminates the need to temporarily form a via.

Especially, it is possible to manufacture a multilayer wiring board in which adverse influence of stubs on electric characteristics can be reduced even with a press-fit connector used in a high-frequency circuit, a high-speed digital circuit, or the like. Moreover, as well as to reduce adverse influence of stubs on electric characteristics, it is possible to facilitate forming a via in a board and manufacturing a multilayer wiring board. It is also possible to facilitate examining a through-hole that is formed in a via for the purpose of pin-joint (insertion) of a press-fit connector and examining the insertion state of a pin.

Moreover, the first wiring board and the second wiring board are joined by a no-flow prepreg; therefore, it is possible to alleviate problems such as a resin flow from the prepreg during heat-pressure bonding in the process of manufacturing a board.

In addition, the first wiring board and the second wiring board can be joined by a sheet-like member made of no-flow or low-flow resin. Accordingly, the first wiring board and the second wiring board can be joined reliably and easily, and the manufacturing cost can be lowered.

Furthermore, manufacturing of a multilayer wiring board is repeated to obtain conductive portions of vias composed of vias and through-holes that are not plated with copper or the like, and having different lengths. Therefore, a desired via can be selected depending on a layer from which a signal is to be taken out through the via. Besides, it is possible to reduce adverse influence of stubs on electric characteristics, and to facilitate forming a via on a wiring board and manufacturing a board.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth.

## Claims

1. A method of manufacturing a multilayer wiring board in which a via is formed, the method comprising:
preparing a first wiring board with the via that electrically connects signal wiring patterns of different layers of the multilayer wiring board, and has a first through-hole an inner surface of which is coated with a conductive film;
preparing a second wiring board with a second through-hole formed at a position substantially matching a position of the first through-hole;
preparing a joint sheet with a third through-hole formed at a position substantially matching positions of the first through-hole and the second through-hole;
stacking the first wiring board and the second wiring board with the joint sheet interposed between the first wiring board and the second wiring board; and
bonding the first wiring board, the second wiring board, and the joint sheet by heat and pressure.

2. The method according to claim 1, wherein the joint sheet is a sheet-like member made of a heat-resistant, no-flow prepreg.

3. The method according to claim 1, wherein the joint sheet is a sheet-like member that has adhesive surfaces and bonds the first wiring board and the second wiring board with the adhesive surfaces.

4. The method according to claim 1, 2, or 3, wherein diameters of the second through-hole and the third through-hole are larger than a diameter of the first through-hole.

5. The method according to any preceding claim, wherein the first through-hole is of a diameter that allows a joint pin of a press-fit connector to be press-fitted in the first through-hole, the press-fit connector electrically connecting to a conductive pattern of the multilayer wiring board.

6. A method of manufacturing a multilayer wiring board in which a via is formed, the method comprising:
preparing a first wiring board with the via that electrically connects signal wiring patterns of different layers of the multilayer wiring board, and has a first through-hole an inner surface of which is coated with a conductive film;
preparing a second wiring board with a second through-hole formed at a position substantially matching a position of the first through-hole;
preparing a first joint sheet with a third-through-hole formed at a position substantially matching positions of the first through-hole and the second through-hole;
preparing a third wiring board with a fourth through-hole formed at a position substantially matching the position of the second through-hole;
preparing a second joint sheet with a fifth through-hole formed at a position substantially matching the positions of the second through-hole and the fourth through-hole;
stacking the first wiring board, the second wiring board, and the third wiring board with the first joint sheet interposed between the first wiring board and the second wiring board and with the second joint sheet interposed between the second wiring board and the third wiring board; and
bonding the first wiring board, the second wiring board, the third wiring board, the first joint sheet, and the second joint sheet by heat and pressure.

7. A multilayer wiring board in which a via is formed at a predetermined position, the multilayer wiring board comprising:
a first wiring board that is provided with the via that electrically connects signal wiring patterns of different layers of the wiring board, and has a first through-hole an inner surface of which is coated with a conductive film;
a second wiring board that is provided with a second through-hole formed at a position substantially matching a position of the first through-hole; and
a joint sheet that is provided with a third through-hole formed at a position substantially matching positions of the first through-hole and the second through-hole, and is interposed between the first wiring board and the second wiring board.

8. The multilayer wiring board according to claim 7, wherein the first wiring board and the second wiring board are bonded together by heat and pressure with the joint sheet interposed between the first wiring board and the second wiring board.

9. The multilayer wiring board according to claim 7 or 8, wherein the joint sheet is a prepreg made of no-flow resin.

10. The multilayer wiring board according to claim 7, wherein the joint sheet is a sheet-like member made of no-flow resin or low-flow resin.
